# DEMANDE DE BREVET EUROPEEN

(11) **EP 2 725 710 A2**
(43) Date de publication de la demande: **30.04.2014**
(21) Numéro de dépôt: 13190117.5
(22) Date de dépôt: 24.10.2013
(51) Int. Cl.: H03F 3/58, H03G 3/30

(54) **Module d'amplification de canal RF à fonction de limitation instantanée de puissance**

(30) Priorité: 26.10.2012 FR 1202862
(71) Demandeur: Thales, 92200 Neuilly Sur Seine (FR)
(72) Inventeur: Mouchon, Grégory, 31600 MURET (FR); Maynard, Jean, 31520 RAMONVILLE SAINT AGNE (FR); Lopez, David, 31037 TOULOUSE (FR); Villemazet, Jean-François, 31550 CINTEGABELLE (FR)
(74) Mandataire: Nguyen, Dominique

(57) **Abrégé**

Module d'amplification de canal radiofréquence pour satellite de communication, comprenant une entrée configurée pour convoyer un signal radiofréquence d'entrée (IN), une sortie configurée pour restituer un signal radiofréquence de sortie (OUT) pré-amplifié destiné à alimenter un amplificateur à tube à onde progressive (13) pouvant être équipé de moyens de linéarisation à pré-distorsion (11), au moins un premier module de contrôle de gain amont (201) disposé en aval de l'entrée et un deuxième module de contrôle de gain aval (203) disposé en aval du premier module de contrôle de gain amont (201) et en amont de tout moyen de linéarisation par pré-distorsion (11). Le module d'amplification (10) de canal comprend de plus un limiteur de puissance instantané (HL) destiné à écrêter les signaux radiofréquence d'entrée (IN) dont le niveau dépasse une valeur de seuil déterminée, le limiteur de puissance instantané étant disposé en série entre ledit premier module de contrôle de gain amont (201) et ledit deuxième module de contrôle de gain aval (203).

## Description

La présente invention concerne un module d'amplification de canal radiofréquence à fonction de limitation instantanée de puissance. Elle s'applique particulièrement au domaine des satellites de communication, et plus spécifiquement à la pré-amplification des signaux d'entrée des amplificateurs de puissance radiofréquence de type tubes à onde progressive équipés ou non de moyens de linéarisation par pré-distorsion.

Dans les satellites de télécommunication, il est nécessaire d'amplifier des signaux radiofréquence reçus dans le but de les réémettre, via des antennes d'émission, à destination d'abonnés, c'est-à-dire de stations de réception, par exemple situées au sol ou dans des porteurs aéroportés. Les dispositifs embarqués dans les satellites permettant la réémission des signaux radiofréquence sont communément désignés « répéteurs ». Un répéteur comporte des chaînes de communication ou canaux et chaque chaîne de communication peut d'une manière typique comprendre, dans sa section de sortie ou « voie descendante », un ou plusieurs amplificateurs à tubes à onde progressive, linéarisés ou non, communément désignés (L)TWTA, selon le sigle correspondant à la terminologie anglaise « (Linearized) Travelling Wave Tube Amplifier », les tubes à onde progressive étant communément désignés TWT. Pour des performances optimales, un TWT est habituellement utilisé proche de sa zone de saturation, et constitue un équipement particulièrement sensible à des niveaux d'entrée supérieurs à sa puissance de saturation. Des niveaux d'entrée trop élevés peuvent en effet entraîner la détérioration, voire la destruction du TWT. Une application de niveaux d'entrée au-delà d'un seuil acceptable est communément désignée par le terme anglais « overdrive ».

Selon des techniques connues, un module d'amplification de type amplificateur de canal peut être disposé en amont du LTWTA, permettant de conditionner le signal radiofréquence appliqué en entrée du TWT, notamment via une pré-amplification. Des amplificateurs de canal connus sont par exemple désignés CAMP, suivant le sigle désignant la terminologie anglaise « Channel AMPlifier », ou encore « DLA », suivant le sigle désignant la terminologie anglaise « Driver Limiter Amplifier ». D'une manière typique, un amplificateur à tube à onde progressive linéarisé LTWTA bénéficie d'une fonction de limitation de puissance de sortie permettant de protéger le TWT lorsque les niveaux des signaux d'entrée sont trop élevés. Cette fonction est d'une manière connue assurée par un limiteur situé en amont du TWT et en aval des moyens de pré-distorsion utilisés pour la linéarisation du TWT, et basé sur une technologie de type MMIC, selon le sigle désignant la terminologie anglaise « Monolithic Microwave Integrated Circuit » à base d'un matériau de type semi-conducteur, par exemple d'arséniure de gallium AsGa. Une telle solution, bien connue et décrite notamment dans le document US 4 701 717, présente cependant deux inconvénients majeurs, exposés ci-après.

Le premier inconvénient est lié à la robustesse de la technologie employée, qui ne permet pas de s'engager sur des durées d'overdrive indéterminées. L'engagement en terme de durée est limité, et dépend du niveau d'overdrive considéré, et des connaissances acquises par une expérience en conditions réelles. Des tests de fatigue, ou « life-tests », peuvent être réalisés, mais l'engagement en terme de durée ne peut être que borné à la durée du life-test, aucun processus de vieillissement accéléré n'existant à ce jour.

Le second inconvénient est lié au fait que le contrôle de gain de l'amplificateur de canal est intégralement réalisé en amont du limiteur, ce qui permet uniquement de protéger l'ensemble de la chaîne de communication du répéteur lorsque le TWT est opéré proche de sa saturation. En effet, opérer le TWT à petit signal est généralement réalisé en diminuant le gain de l'amplificateur de canal situé en amont du LTWTA. Dans ce cas, le limiteur de sortie est opéré dans sa zone linéaire et non plus proche de sa saturation. Il n'est donc plus en mesure d'écrêter des signaux de brouillage volontaire ou involontaire, ce phénomène pouvant engendrer une dégradation importante du bilan de liaison et donc des performances du système.

Une autre solution de limitation connue consiste à utiliser une boucle de régulation de puissance à seuil telle que décrite dans le document US 4 701 717, cependant, cette solution présente un temps de réponse trop important incompatible du filtrage de signaux impulsionnels provenant d'un brouilleur ou d'un overdrive de durée inférieure à ce temps de réponse.

Ainsi, il n'est pas connu à ce jour de solution permettant de protéger un tube à onde progressive linéarisé quel que soit son point de fonctionnement, de fort recul ou à saturation, en cas de brouilleur ou d'overdrive permanent, qu'il soit continu ou impulsionnel. Il n'est donc pas possible d'assurer un niveau de service minimal, c'est-à-dire de satisfaire à des exigences minimales de communication, en cas de présence d'un brouilleur ou d'un overdrive permanent.

Un but de la présente invention est de pallier au moins les inconvénients précités, en proposant une solution matérielle permettant de protéger le TWT de signaux d'entrée de niveaux élevés, transitoires ou continus, et permettant une tenue en conditions d'overdrive pour une durée correspondant au moins à la vie du satellite. La solution proposée par la présente invention implique l'introduction d'un limiteur instantané disposé de manière judicieuse dans le module d'amplification de canal radiofréquence situé en amont du TWTA ou du LTWTA, afin de procurer une protection efficace du TWT et d'optimiser les performances du système de communication en présence d'un brouilleur ou d'un overdrive, quel que soit le point d'opération choisi du TWT (à saturation ou en recul). Selon l'invention, le limiteur instantané, dit limiteur « hard », est connecté en série entre deux éléments à gain variable, par exemple de type amplificateur à gain variable ou ensemble d'amplificateur à gain variable et d'atténuateur variable connectés en série. Ainsi positionné en amont d'un éventuel linéariseur et donc en amont des moyens de pré-distorsion du TWT, le limiteur permet de fournir des performances de limitation suffisantes quel que soit le point d'opération, à saturation ou en recul, du LTWTA, ce qui n'est pas rendu possible par les solutions connues présentant un limiteur en sortie des moyens de pré-distorsion. L'élément à gain variable situé en amont du limiteur instantané permet de fournir une performance de limitation quelle que soit la puissance d'entrée du module d'amplification radiofréquence.

Un avantage de l'invention est qu'elle permet de plus, par réglage, une adaptabilité améliorée de la sévérité de la limitation de puissance, en fonction des besoins spécifiques des missions.

A cet effet, l'invention a pour objet un module d'amplification de canal radiofréquence pour satellite de communication, comprenant une entrée configurée pour convoyer un signal radiofréquence d'entrée , une sortie configurée pour restituer un signal radiofréquence de sortie pré-amplifié destiné à alimenter un amplificateur à tube à onde progressive pouvant être équipé de moyens de linéarisation par pré-distorsion, au moins un premier module de contrôle de gain amont disposé en aval de l'entrée et un deuxième module de contrôle de gain aval disposé en aval du premier module de contrôle de gain amont et en amont de tout moyen de linéarisation par pré-distorsion. Le module d'amplification de canal comprend de plus un limiteur de puissance instantané destiné à écrêter les signaux radiofréquence d'entrée dont le niveau dépasse une valeur de seuil déterminée, le limiteur de puissance instantané étant disposé en série entre ledit premier module de contrôle de gain amont et ledit deuxième module de contrôle de gain aval.

Dans un mode de réalisation de l'invention, le limiteur instantané de puissance peut être formé par un limiteur à diodes.

Dans un mode de réalisation de l'invention, ladite valeur de seuil déterminée peut être une valeur prédéterminée.

Dans un mode de réalisation de l'invention, le module d'amplification de canal peut comprendre de plus des moyens d'ajustement permettant d'ajuster ladite valeur de seuil déterminée.

Dans un mode de réalisation de l'invention, le module d'amplification de canal peut comprendre en outre un linéariseur par pré-distorsion relié audit module de contrôle de gain aval.

Dans un mode de réalisation de l'invention, le module d'amplification de canal peut comprendre en outre un deuxième limiteur de puissance disposé en aval du linéariseur.

La présente invention a également pour objet un répéteur pour satellite de communication comprenant au moins un amplificateur à tube à onde progressive et un module d'amplification de canal selon l'un des modes de réalisation décrits, dont la sortie attaque l'entrée de l'amplificateur à tube à onde progressive.

D'autres caractéristiques et avantages de l'invention apparaîtront à la lecture de la description, donnée à titre d'exemple, faite en regard des dessins annexés qui représentent :
- figure 1 : un diagramme illustrant de manière synoptique un amplificateur de canal radiofréquence en lui-même connu de l'état de la technique ;
- figure 2 : un diagramme illustrant un module d'amplification de canal radiofréquence à fonction de limitation de puissance, selon un mode de réalisation de l'invention ;
- figure 3 : des courbes illustrant le niveau de sortie d'un module d'amplification de canal, en fonction du niveau d'entrée, selon un mode de réalisation de l'invention ;
- figure 4 : un diagramme illustrant un canal de communication d'un répéteur de satellite comportant un module d'amplification, selon l'invention.

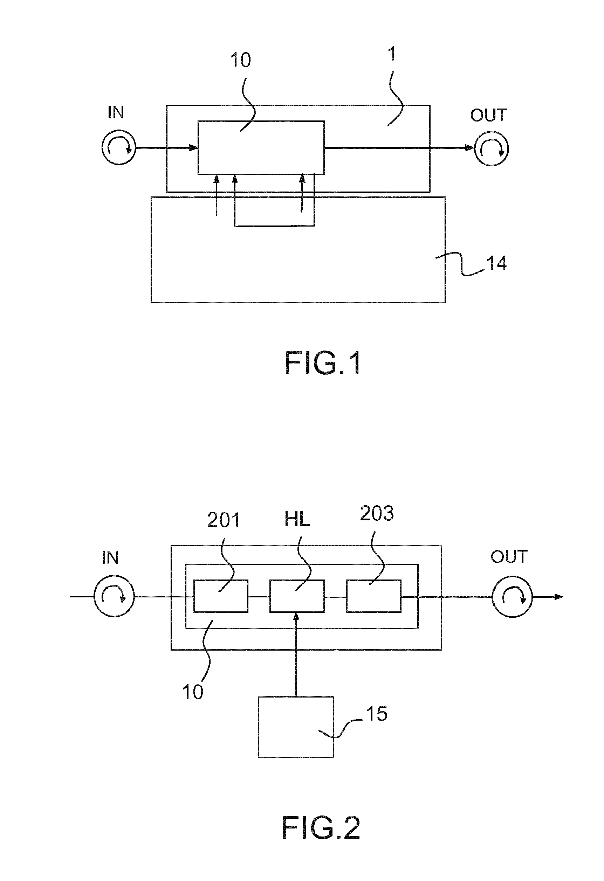

En référence à la figure 1, un amplificateur de canal radiofréquence 1 peut d'une manière typique comprendre un module d'amplification 10, à l'entrée duquel un signal radiofréquence d'entrée IN est appliqué et dont la sortie restitue un signal radiofréquence de sortie OUT amplifié. L'amplificateur de canal radiofréquence 1 peut comprendre un module de commande 14 générant des signaux de commande à l'intention du module d'amplification 10, plus précisément des signaux de contrôle de gain à l'intention d'une pluralité d'atténuateurs et d'amplificateurs de faible niveau disposés en cascade, ainsi que cela est décrit ci-après en référence à un exemple illustré par la figure 2. Des signaux de contrôle peuvent être générés en fonction de différents paramètres, tels que par exemple des niveaux de signaux, la température, quantifiés par des détecteurs pouvant être compris dans le module d'amplification 10. En pratique, les éléments constituant le module de commande 14 peuvent également être intégrés dans un conditionneur de puissance électronique, communément désigné suivant le sigle EPC correspondant à la terminologie anglaise « Electronic Power Conditioner », associé également à un TWT, non représenté sur la figure, dont l'entrée est attaquée par le signal de sortie OUT.

En référence à la figure 2, le module d'amplification 10 de l'amplificateur de canal radiofréquence 1 tel que décrit précédemment en référence à la figure 1, peut comprendre un module de contrôle de gain amont 201, le module de contrôle de gain amont 201 comprenant des éléments à gain variable par exemple une pluralité d'atténuateurs à contrôle de flux, communément désignés par le sigle FCA désignant la terminologie anglaise « Flux Control Attenuator », et une pluralité d'amplificateurs, par exemple d'amplificateurs faible niveau, communément désignés par le sigle LLA correspondant à la terminologie anglaise « Low Level Amplifier », disposés en cascade. Selon une spécificité de la présente invention, un limiteur de puissance instantané HL est disposé en aval du module de contrôle de gain amont 201, et en amont d'un module de contrôle de gain aval 203. Le module de contrôle de gain aval 203 peut comporter des éléments à gain variable, par exemple une pluralité d'amplificateurs et d'atténuateurs disposés en cascade, à l'instar du module de contrôle de gain amont 201 décrit ci-dessus.

L'exemple de structure du module d'amplification 10 illustré par la figure 2 n'est aucunement limitatif de la présente invention. D'une manière générique, il est proposé selon la présente invention que le module d'amplification 10 comprenne :
- au moins un module de contrôle de gain amont 201 et au moins un module de contrôle de gain aval 203,
- un limiteur de puissance instantané HL disposé entre le module de contrôle de gain amont 201 et le module de contrôle de gain aval 203, selon une spécificité de la présente invention.

Le module d'amplification 10 est placé en amont d'un tube à onde progressive TWT 13 équipé ou non de moyens de linéarisation 11 incluant un moyen de pré-distorsion, les moyens de linéarisation 11 pouvant également inclure un deuxième limiteur de puissance, non représenté, permettant de limiter la puissance en entrée du TWT. Le limiteur de puissance instantané HL peut être basé sur une technologie robuste adaptée à la tenue en overdrive permanent, et peut par exemple être formé par un limiteur à diodes. Le limiteur de puissance HL permet d'écrêter les signaux dont le niveau excède une valeur de seuil déterminée.

La valeur de seuil déterminée peut par exemple être une valeur de seuil prédéterminée, ou avantageusement, des moyens d'ajustement 15 peuvent permettre à un utilisateur d'adapter la valeur de seuil.

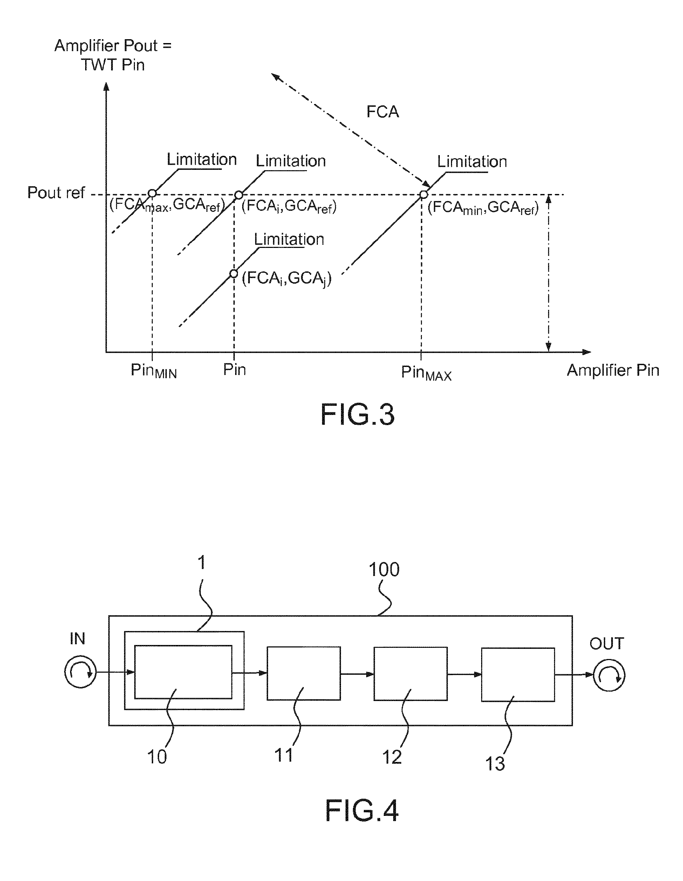

La fonction de limitation de puissance assurée par le limiteur de puissance instantané HL permet de limiter la puissance d'entrée du TWT, linéarisé ou non, en cas d'overdrive permanent, sur toute la gamme de puissance d'entrée du module d'amplification 10 de canal radiofréquence, ainsi que cela est décrit ci-dessous en référence à la figure 3.

La figure 3 est une représentation graphique illustrant le niveau de sortie d'un module d'amplification de canal incluant un limiteur de puissance instantané, selon un mode de réalisation de l'invention, en fonction du niveau d'entrée. L'axe des abscisses porte des valeurs de puissance Pin du signal radiofréquence d'entrée IN. L'axe des ordonnées porte des valeurs de puissance Pout du signal radiofréquence de sortie OUT, c'est-à-dire des valeurs de la puissance d'entrée du signal appliqué en entrée du TWT, linéarisé ou non, destiné à être disposé en aval du module d'amplification 10 de canal radiofréquence. Sur la figure 3, une valeur du gain aval de référence GCAref correspond à la configuration du gain aval GCA permettant de saturer le TWT pour tout couple gain amont FCA / puissance d'entrée Pin saturant le TWT. Le limiteur de puissance instantané HL étant positionné entre les fonctions gain amont et gain aval, ainsi que cela est décrit précédemment en référence à la figure 2, la fonction de limitation de puissance est disponible pour tout gain aval GCAj et donc tout point d'opération du TWT (pour un niveau de puissance en entrée du limiteur de puissance instantané HL constant).

Il est à observer qu'un autre avantage de la présente invention est lié au fait que la disposition particulière du limiteur de puissance instantané HL permet d'adapter la sévérité de la limitation de puissance en fonction des spécificités des missions envisagées. Par exemple, si la mission nécessite que la limitation soit sévère, il est possible d'augmenter le gain en amont du limiteur de puissance instantané HL, c'est-à-dire le gain du premier module de contrôle de gain 201, en référence à la figure 2 décrite précédemment, tout en diminuant le gain du deuxième module de contrôle de gain 203. D'une manière similaire, si la mission nécessite au contraire une limitation moins sévère, il est possible d'augmenter le gain du deuxième module de contrôle de gain 203, de manière à attaquer le limiteur de puissance instantané HL plus en recul, c'est-à-dire à opérer le limiteur dans une zone de fonctionnement plus linéaire, réduisant ainsi la performance de limitation, avec un gain moindre pour ce qui concerne le premier module de contrôle de gain 201.

La figure 4 illustre la position du module d'amplification 10 de canal dans un canal de communication d'un répéteur 100 de satellite. Le module d'amplification 10 équipé du limiteur de puissance instantané HL est placé en amont d'un amplificateur de puissance à tube à ondes progressive 13. L'amplificateur à tube à onde progressive peut optionnellement comporter des moyens de linéarisation par pré-distorsion 11 et un deuxième limiteur de puissance 12 disposés entre le module d'amplification 10 et l'amplificateur à onde progressive 13, le deuxième limiteur de puissance 12 étant disposé en aval du linéariseur (11).

Un module d'amplification 10 de canal selon l'un quelconque des modes de réalisation de l'invention décrits ci-dessus, peut tout aussi bien s'appliquer à des signaux dans la bande Ka (soit pour des fréquences des signaux reçus comprises typiquement entre17 et 23 GHz), ou encore dans les bandes C (de 3,4 GHz à 4,2 GHz) et Ku (de 10,7 GHz à 12,75 GHz) et toute autre bande de fréquence (L, S, Q ...).

## Revendications

1. Module d'amplification de canal radiofréquence pour répéteur de satellite de communication, comprenant une entrée configurée pour convoyer un signal radiofréquence d'entrée (IN), une sortie configurée pour restituer un signal radiofréquence de sortie (OUT) pré-amplifié destiné à alimenter un amplificateur à tube à onde progressive (13) pouvant être équipé de moyens de linéarisation par pré-distorsion (11), au moins un premier module de contrôle de gain amont (201) disposé en aval de l'entrée et un deuxième module de contrôle de gain aval (203) disposé en aval du premier module de contrôle de gain amont (201) et en amont de tout moyen de linéarisation par pré-distorsion (11), le module d'amplification (10) de canal étant **caractérisé en ce qu'il** comprend de plus un limiteur de puissance instantané (HL) destiné à écrêter les signaux radiofréquence d'entrée (IN) dont le niveau dépasse une valeur de seuil déterminée, le limiteur de puissance instantané étant disposé en série entre ledit premier module de contrôle de gain amont (201) et ledit deuxième module de contrôle de gain aval (203).

2. Module d'amplification de canal (10) selon la revendication 1, **caractérisé en ce que** le limiteur instantané de puissance (HL) est formé par un limiteur à diodes.

3. Module d'amplification de canal (10) selon la revendication 1, **caractérisé en ce que** ladite valeur de seuil déterminée est une valeur prédéterminée.

4. Module d'amplification de canal (10) selon la revendication 1, **caractérisé en ce qu'il** comprend de plus des moyens d'ajustement (15) permettant d'ajuster ladite valeur de seuil déterminée.

5. Module d'amplification de canal (10) selon l'une quelconque des revendications précédentes, **caractérisé en ce qu'il** comprend en outre un linéariseur par pré-distorsion (11) relié audit module de contrôle de gain aval (203).

6. Module d'amplification de canal (10) selon la revendication 5, **caractérisé en ce qu'il** comporte en outre un deuxième limiteur de puissance (12) disposé en aval du linéariseur (11).

7. Répéteur pour satellite de communication comprenant au moins un amplificateur à tube à onde progressive (13), **caractérisé en ce qu'il** comprend de plus un module d'amplification de canal (10) selon l'une quelconque des revendications précédentes, dont la sortie attaque l'entrée de l'amplificateur à tube à onde progressive (13).
